# EUROPEAN PATENT APPLICATION

(11) **EP 3 495 911 A1**
(43) Date of publication of application: **12.06.2019**
(21) Application number: 17206443.8
(22) Date of filing: 11.12.2017
(51) Int. Cl.: G05D 7/06, G05B 13/04, B67C 3/00, G05B 17/02

(54) **SYSTEM AND METHOD FOR FILLING A CONTAINER WITH A FLUID AND/OR OPERATING A MIXING SYSTEM**

(71) Applicant: Siemens Aktiengesellschaft, 80333 München (DE)
(72) Inventor: MAERTENS, Philip, 8820 Torhout (BE)

(57) **Abstract**

A method of filling a container (C) with a fluid (F) by way of at least one automation component (AC), the method comprising, through operation of at least one processor: determining (S1) a set of control parameters based on simulating filling of the container (C) at least partially with the fluid (F) by way of the automation component (AC), wherein the simulating takes into account one or more properties (P1, ..., Pn) of the container (C), the fluid (F) and/or the at least one automation component (AC); and
causing (S2) the at least one automation component (AC) to at least partially fill the container (C) according to at least one of the control parameters of the set of control parameters determined.

## Description

The present disclosure is directed, in general, to computer-aided design (CAD), computer-aided manufacturing (CAM), computer-aided engineering (CAE), visualization, simulation, and manufacturing systems, product data management (PDM) systems, product lifecycle management (PLM) systems, manufacturing operations systems (MOM) and similar systems, that are used to create, use, and manage data for products and other items (collectively referred to herein as product systems).

Automation systems may be used to facilitate manufacturing products. Such systems may benefit from improvements. For example from patent application publication US 20060241791 A1 a method for simulating a process line has become known. Therein a machine arrangement is simulated in its processing behavior with use of static building data, static system data, process data and a simulation model of the machine arrangement components as input variables.

In order to fill containers with beverages an apparatus according to patent application publication US 3443608 A has become known. Obviously, it is always desirable to provide a quicker container filling action wherein carbonated beverages can be forced into or otherwise filled into containers to fill them with such beverages with a minimum of foaming action. Also, the use of readily exchangeable, removable and/or replaceable filling heads, e.g. nozzles, therein is desirable.

Due to the fact that also the bottle shapes may change rapidly and the variations in different products are increasing, new and flexible optimized filling methods are needed. Existing machines have to be adapted to have bigger throughput and consume less energy. An apparatus that could flexibly adapt to shape changes and product changes would therefore provide a great added value.

In the case of mixing, a cement mixing system simulator and simulation method has become known from patent application publication US5320425 A. This method comprises recording data identifying a performance evaluation of an operator in response to a comparison between at least one of the determined material flow properties and a corresponding predetermined characteristic.

Furthermore control system design for a mixing system with multiple inputs has become known from patent application publication US2009118866 A1. The method comprises introducing the at least two materials into a physical system and combining the at least two materials to form a mixture thereof. The method also comprises independently controlling a desired characteristic of the mixture and a desired parameter of the physical system, wherein the controlling is based in part on estimating a disturbance.

Automatic cement mixing and density simulator and control system and equipment for oil well cementing has also become known from patent application publication US 5571281 A.

Due to the fact that by mixing one or more (different) substances the plant operator may not know when exactly the products have reached their optimal mixing status, the mixing time is performed much longer than needed in order to make sure sufficient mixing is achieved. This can be double of the optimal time or even longer. Thus, in particular in the food and beverages industry mixing times are typically programmed much longer than needed, since the actual conditions of the current batch are not taken into account when the master recipe is configured, configured e.g. by way of one or more control parameters. So the mixing is performed for a long time, in order to make sure that the product is "well mixed", whatever the specific conditions of the batch are.

Furthermore, no effective coupling between a simulation component and an automation component, governing the manufacturing process, has been realized so far.

It is thus an object to mitigate the problems identified. The present disclosure thus relates to a method of filling a container with a fluid by way of at least one automation component. The invention further relates to a method of operating a mixing system. Further embodiments include respective computer program products.

According to a first aspect, a method of filling a container with a fluid by way of at least one automation component, may comprise and/or initiate through operation of at least one processor: determining a set of control parameters based on simulating filling of the container at least partially with the fluid by way of the automation component, wherein the simulating takes into account one or more properties of the container, the fluid and/or the at least one automation component. The method may further comprise and/or initiate through operation of the at least one processor: causing the at least one automation component to at least partially fill the container according to at least one of the control parameters of the set of control parameters determined.

According to a second aspect, a method of operating a mixing system, the mixing system comprising a container, at least one substance to be mixed, and at least one automation component for performing the mixing, may comprise and/or initiate through operation of the at least one processor: determining a set of control parameters based on simulating mixing of the at least one substance by way of the automation component, wherein the simulating takes into account one or more properties of the container, the least one substance and/or the at least one automation component. The method may further comprise and/or initiate through operation of the at least one processor: causing the at least one automation component to mix the at least one substance in the container according to at least one of the control parameters of the set of control parameters determined.

Furthermore automation systems for carrying out any one of the method steps of the first and/or second aspect are disclosed. That is to say, an automation system operative to perform any one of the method steps of the first and/or second aspect.

Before describing further aspects in more detail, it should be understood that various definitions for certain words and phrases are provided throughout this patent document, and those of ordinary skill in the art will understand that such definitions apply in many, if not most, instances to prior as well as future uses of such defined words and phrases. While some terms may include a wide variety of embodiments, the appended claims may expressly limit these terms to specific embodiments. It should also be appreciated that features explained in the context of the suggested methods may also be comprised by the suggested system by appropriately configuring and adapting the system and vice versa.

The foregoing has outlined rather broadly the technical features of the present disclosure so that those skilled in the art may better understand the detailed description that follows. Additional features and advantages of the disclosure will be described hereinafter that form the subject of the claims. Those skilled in the art will appreciate that they may readily use the conception and the specific embodiments disclosed as a basis for modifying or designing other structures for carrying out the same purposes of the present disclosure. Those skilled in the art will also realize that such equivalent constructions do not depart from the spirit and scope of the disclosure in its broadest form.

Below, a detailed description is provided using the embodiments illustrated in the figures.
- Fig. 1: illustrates an embodiment of a filling line.
- Fig. 2: illustrates a more detailed embodiment of a filling line.
- Fig. 3: illustrates exemplary parameters of a filling line.
- Fig. 4: illustrates another embodiment of a filling line.
- Fig. 5: illustrates an embodiment of a mixing assembly.
- Fig. 6: illustrates another embodiment of a mixing assembly.
- Fig. 7: illustrates still another embodiment of a mixing assembly.
- Fig. 8: illustrates an embodiment of a manufacturing system.
- Fig. 9: illustrates an exemplary embodiment of an improved a manufacturing system.
- Fig.10 to Fig.15: illustrate exemplary steps of a filling method.
- Fig.16 to Fig.19: illustrate exemplary steps of a mixing method.
- Fig. 20: illustrates an apparatus for carrying out a filling process.
- Fig. 21: illustrates an apparatus for carrying out a mixing process.

Various technologies that pertain to systems and methods for filling and/or mixing will now be described with reference to the drawings, where like reference numerals represent like elements throughout. The drawings discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged apparatus. It is to be understood that functionality that is described as being carried out by certain system elements may be performed by multiple elements. Similarly, for instance, an element may be configured to perform functionality that is described as being carried out by multiple elements. The numerous innovative teachings of the present application will be described with reference to exemplary non-limiting embodiments.

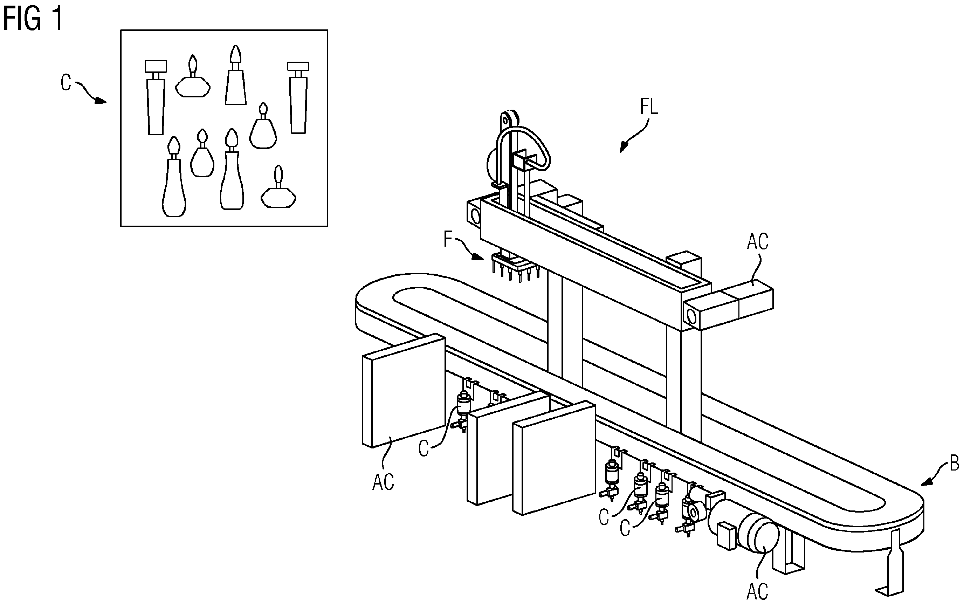

With reference to Fig. 1, an exemplary automation system is illustrated in the form of a filling line.

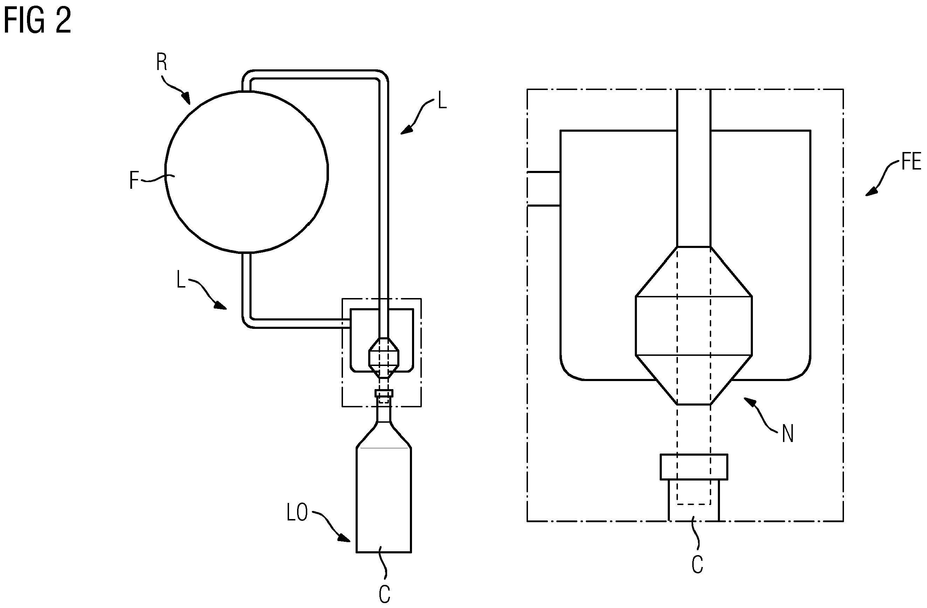

Containers C, namely bottles, are fed in the direction indicated by the arrow by means of a conveyor belt B. A central control unit or, expressed differently, controller or system which includes a process controller which, among other things, controls the operation of the filling line FL. A filling element FE, which may comprise a nozzle N and/or a valve, may be located above the corresponding conveyor belt B. An external connecting line L, e.g. one or more pipes, may be used to connect the filling line FL to an external reservoir or mixer to supply the fluid to be filled, cf. Figure 2.

The filling line FL may thus comprise a revolving system, that is, it has at a rotor which, as is known to a person with skill in the art, rotates about a vertical machine axis. Further one or more filling locations LO are provided that may be uniformly distributed in angular positions and these one or more filling locations are respectively served by one or more filling elements FE. The containers C that are presented by a conveyor B are directed to the individual filling locations LO by a bottle input or expressed differently, loading, portion and the filled bottles are removed at a bottle output or expressed differently, unloading, portion from the filling locations LO and may be returned to the conveyor belt B.

The outlined filling process may be controlled by one or more sensors. Individual process steps may also be controlled by the one or more sensors. The one or more sensors, e.g. pressure sensors, provide the opportunity to monitor and/or diagnose the individual filling elements during the operation of the filling line FL.

Furthermore one or more valves, which may as well as the sensors be part of the one or more filling elements FE, may control filling of the container with a fluid, for example carbonated beverages, particularly soft drinks and mineral water, in glass and plastic containers.

As shown in Figure 1 the containers C may different shapes and sizes. In general a container C may comprise at least a bottle, a barrel, a keg, a tube, a tank or any combination thereof.

The automation system may comprise a processor configured via executable instructions included in a memory. This processor may execute instruction controlling the filling process, e.g. with respect to time. The controller being configured to receive from a corresponding sensor or valve or other automation component said at least one indication, e.g. representative of a sensed pressure related to at least one corresponding container; and configured to control at least one control parameter related to filling a container C in the filling line FL; said controller being further configured to control said automation component AC for at least one process parameter of said filling line.

It should be understood that one or more automation components AC, such as the filling element FE and/or the controller comprising the processor may also be understood to form one or more automation components AC. That is to say the automation system comprises one or more automation components AC. The one or more automation components AC may be realized by way of hardware and/or software.

Figure 2 shows a detailed view of a filling line FL. A filling element FE is connected via one or more pipes L to a reservoir R containing the fluid F to be filled in the one or more containers C. As can be seen, different control parameters may govern the filling process. In particular the geometry of the nozzle and the bottle(-neck) determine the behavior of the fluid F that is filled in the respective container C. In particular the valve elevation, i.e. the distance of the valve outlet to the container C and the distance of the fluid stream to the interior walls of the bottle(-neck) determine the formation of foam, in particular if carbonated fluids are to be filled. Of course, the velocity of the fluid, e.g. when entering the container C, and/or pressure differences play an important role for a filling line and a filling process respectively. These different properties P1, ..., Pn, which may correspond to the control parameters, may be determined and/or recorded and may serve as control parameters for adjusting operation of the automation system, i.e. one or more components of the automation system. One or more properties P1, ..., Pn may thus be stored, e.g. in the form of one or more control parameters, e.g. as a set of control parameters in a (central) storage of an automation system.

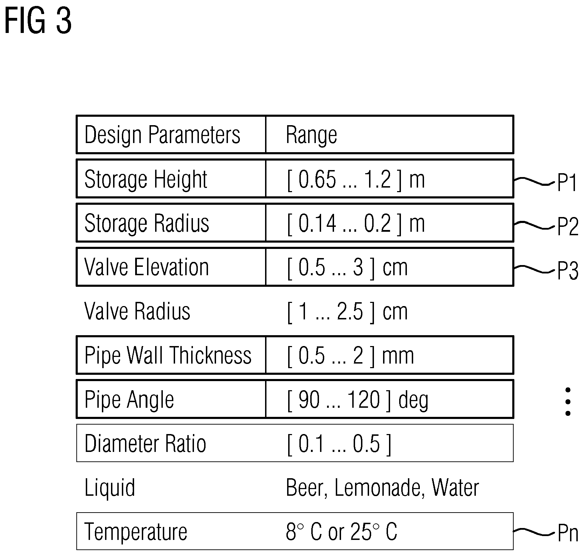

In Figure 3 different properties P1, ..., Pn governing the filling process are shown. For example, the height of the reservoir (storage) and its radius may be decisive for the filling process. Furthermore the valve elevation, i.e. its distance to the opening of the container as well as the valve radius may play an important role. Also the connecting pipes L properties such as the pipe wall thickness and/or its bending angle may be considered. In addition the type of fluid F and its properties such as carbonization, viscosity and/or temperature may be considered when adjusting the filling process. The adjustment of the behavior of the automation components AC as mentioned above may be carried out by control instructions which in turn are governed by certain control parameters. The control parameters in turn may be derived from the properties P1, ..., Pn of the fluid, the one or more (different) containers C and/or the properties of the automation components AC.

It should be pointed out that in general an automation system may function according to a certain set of control parameters, e.g. the parameters available for adjusting the functions and/or functionalities of the one or more automation components AC. This may as well apply to the process of mixing described further down.

Due to the fact that the bottle shapes may change rapidly and the variations in different products are increasing, new and flexible optimized filling methods are needed. Existing automation components, such as machines, have to be adapted to have bigger throughput and consume less energy. An automation component that can flexibly adapt to shape changes and product changes is a great added value. Thus, optimizing the performance of a filling process using a connection of one or more automation components with a simulation component and using the actual process parameters as input for the simulation and using new set points, i.e. one or more control parameters of a set of control parameters determined by the automation component, to adapt the filling process, is proposed.

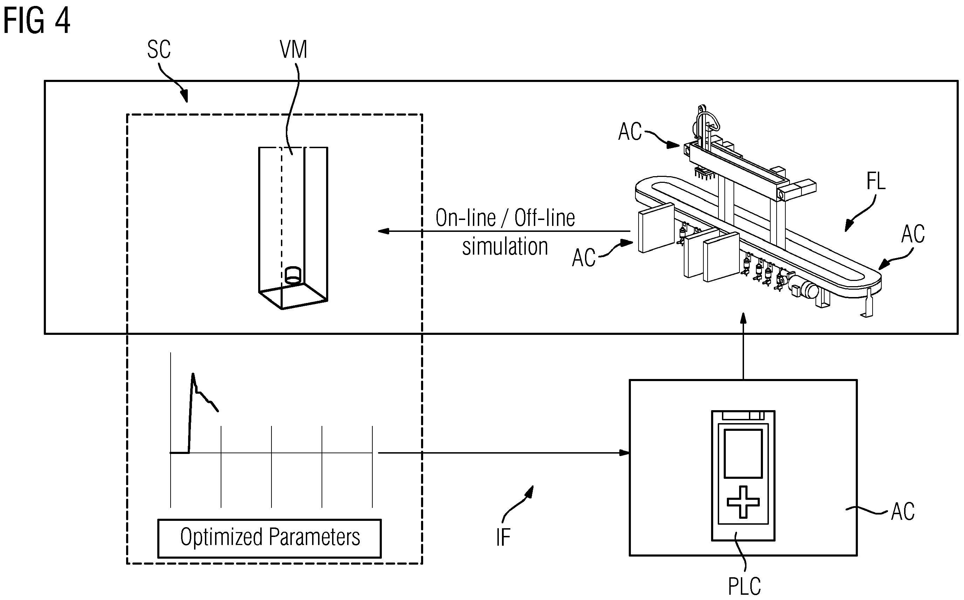

Now turning to Figure 4, through the use of a Digital Twin, i.e. a virtual model VM, of a filling line FL, the filling process can be optimized in production by simulating the behavior of the filling of the product in process and adapting the control parameters in the automation component AC, such as an automation controller, PLC, in particular after the filling has been started. The simulation can be targeted to get a better qualitative filling, a faster filling and/or an energy consumption optimization. The online connection between the simulation data of the digital twin, denoted as VM, and automation controller AC is essential and unique to optimize the performance of a running machine. Thus, properties of the one or more automation components AC may be aggregated in a virtual model VM of the respective one or more automation component AC. The same applies to one or more fluids F and/or one or more containers C which may have their respective virtual models.

The virtual model VM, also renowned in the industry as digital twin, may have one or more components which themselves are a digital model of a corresponding automation component AC, a container C and/or the fluid F. The virtual model VM may be part of the simulation component SC or may itself form the entire simulation component SC.

In the food and beverage industry the strategy for the filling process of production machines is typically programmed based on individual knowledge or by performing additional empiric test runs - which leads to non-optimal results or additional effort if control parameters for the fluid F and/or the container C are changing. In particular, in case of small lot size production, the optimization process is either not optimal, leading to non-optimal performance for the machine, or leads to additional effort. Thus, overall machine performance by optimizing the time and quality critical filling process in filling installations FL may be increased.

The simulation can be used to provide various optimized filling strategies targeting small lot sizes with variations in fluidics and container shapes. The simulation can even be used to fine tune in process, that is to say online, optimization through a connection with an industrial automation controller, e.g. a Simatic S7 PLC. Improvement in quality and speed, especially for small lot size production may thus be achieved. Hence, less manual empiric testing is required.

Two possible embodiments are described in the following:

### Off-line solution:

The filling strategy, e.g. the movement of one or more filling nozzles and/or one or more containers C, is simulated offline, that is to say no filling is taking place, for a relevant set of control parameters and/or properties, e.g. of the fluid F, the container C and/or the automation component AC. An optimal strategy result is stored (file, database). The optimal strategy may be subject to one or more conditions set, e.g with respect to time, energy and/or filling level. An interface IF with the automation component AC, such as an automation controller, in particular a PLC, picks up the relevant strategy, e.g. in the form of one or more control parameters out of a set of control parameters determine by the simulation component SC, for a filling process and automatically adapts the automation behavior. New conditions, e.g. due to updated properties P1, ..., Pn, for example caused by a change in fluid F, container C and/or automation component AC, can again be simulated offline and published to a central storage or directly transmitted to the automation component, e.g. the above mentioned automation controller.

### On-line solution:

An interface IF between the automation component AC, e.g. the above mentioned automation controller, such as a PLC, and the simulation component SC, comprising one or more virtual models VM, exchanges control parameters. Once the filling process is started, the simulation starts in parallel and uses actual control parameters (fill level, material related parameters, etc.) to start the optimization calculation. After a reasonable time, the automation component AC is receiving new set points, e.g. in the form of one or more control parameters determined by the simulation component SC, that influence the process, overwriting the current set points, e.g. in the form of one or more control parameters determined by the simulation component, of the control recipe. The connection with the automation component AC permits to change setpoints in full operation. Ideally, both, the simulation component SC and the automation component AC run on the same piece of hardware (e.g. a Multifunctional Platform S7-1500 PLC).

Customers will be interested in this specific added value for them (better quality, reduction of process time, thus reduction of energy consumption and increasing throughput).

The above embodiments may be particularly applicable for bottle and packaged food filling machines. Another advantage is the increased production rate, the reduced time to market for new products and brands, e.g. due to new bottle design, and that the filling material properties may be taken into account.

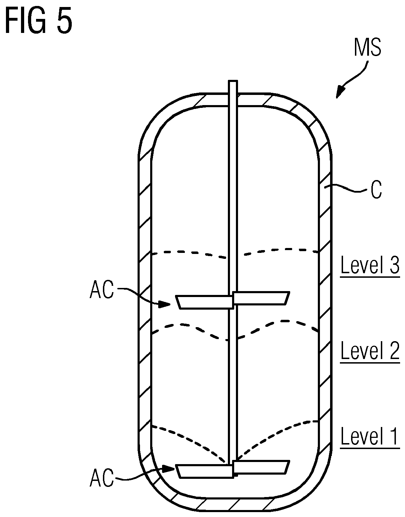

Now turning to Figure 5, a container C, in this case a tank, being used for a mixing process in which the substance S to be mixed is caused to circulate, is shown. By way of example the substance S is one of: at least one component of a battery, at least one component of a pharmaceutical product, a chemical substance. Of course other substances S may be subject to mixing.

In this case the mixer MS comprises a rotatable shaft to which stirring elements are attached, i.e. forming an impeller. However other stirring or mixing elements may exist. For example, mixing may be achieved by way of a pump causing the material in the tank to circulate. The shaft and the mixing element may be an automation component AC already.

Returning to the present case of an impeller, in the case of the known mixing mechanisms, the high rotational velocity of the impeller may cause detrimental effects. For example, there may be no mixing effect or in another case high rotational speeds are necessary. High rotational speeds are disadvantageous not only because of the enormously high energy consumption, but also because of the unavoidable splashing of the stirred substance.

Furthermore the fill level of the substance in the container may play an important role when stirring a substance S, as e.g. the fill level may be above or below some of the stirring elements and thus mixing of the substance is affected. Hence, the operation of the mixer MS may dependent on different parameters such as flow behavior with change of the substance fill level and/or the possibility of foaming. These challenges require the investigation of flow behavior in the container C and the identification of conditions that limit productivity. Thus simulating the fill level, e.g. by way of a 3D model, may improve operation, e.g. by way of determining surface turbulence and/or considering fill level profiles dependent on the fill level height in relation to the position of the stirring elements. Thereby an optimum fill level of the container C that causes a maximum volume turbulence (which maximizes mixing effect) and/or a minimum surface turbulence (which minimizes foaming) may be determined. Thus optimum operating conditions may be determined by way of the simulation. It should be understood that the according simulation may be carried out by a simulation component SC, e.g. implement in software.

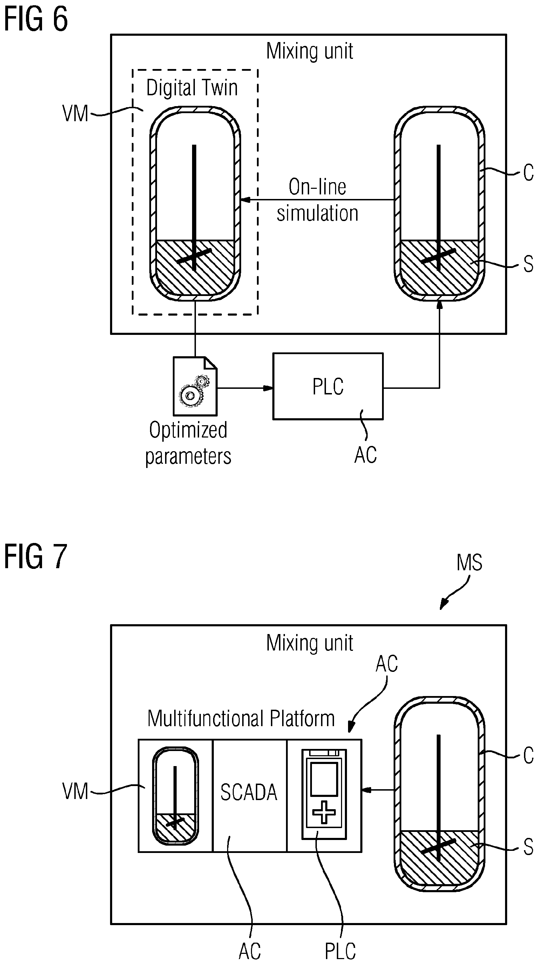

As can be seen by way of Figure 6, an online simulation and optimization of the mixing process may be performed. Online simulation of flow behavior to simulate the mixing of different substances S may also be performed before the production is performed. The simulation may identify of conditions with optimal performance based on the simulation based on requirements of the plant operator (energy consumption, time,..). Subsequently the optimized control parameter set may be transmitted to the automation component AC, e.g. a PLC, before or during the mixing process.

An simulation component SC, corresponding to or comprising one or more virtual models VM, may be used that simulated the mixing process. The simulation component SC may retrieve relevant mixing parameters, such as control parameters from the one or more automation components AC, such as a PLC. Alternatively the simulation component may retrieve properties of the container C, the substance(s) S and/or the automation component(s) AC. Furthermore the simulation component SC may derive the respective control parameters from the properties P1, ..., Pn of the substance (s) S, the container C and/or the automation component(s) AC. A set of optimized control parameters may be output by the simulation component SC and transmitted to the one or more automation components AC, i.e. the PLC. To this end, the simulation component SC may be located on a separate hardware or may be comprised on the same hardware or platform as the automation component AC, e.g. the PLC.

Figure 7 shows an embodiment comprising a single platform on which the simulation component SC and the automation component AC, or a part thereof, is located. The simulation component SC may perform an online simulation of flow behavior to simulate the mixing of different one or more substances S before the production. The simulation component SC may identify one or more conditions with optimal performance based requirements of the plant operator (energy consumption, time, etc.). The optimized control parameter set, that is to say one or more control parameters, may be transmitted to the automation component AC before or during the mixing process. The simulation component SC may comprise one or more virtual models VM of the automation component AC, the container C and/or the one or more substances S to be mixed. For example, both, one or more automation components AC, e.g. a automation controller, such as PLC, and the simulation component SC may be integrated in a Supervisory control and data acquisition (SCADA).

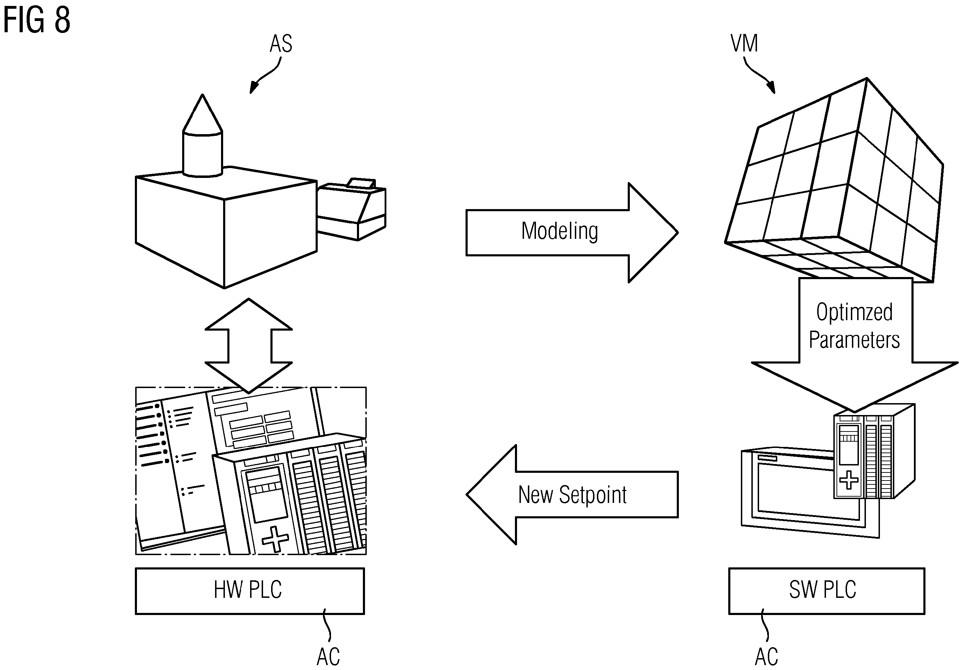

Now turning to Figure 8, another more abstract embodiment of the method and system proposed is disclosed herein. In a first step simulation of a production plant may be performed based on a set of control parameters retrieved from the one or more automation components AC of the automation system. Alternatively, historic data may be retrieved based on which the process in the automation system AS is performed. The historic set of control parameters may be retrieved from a central storage in which data from previous operation of the automation system is stored. The simulation component SC may determine a (optimized) set of control parameters. The set of control parameters is then provided to an automation component. The automation component AC may be implemented by way software and/or hardware. In the example of Figure 8 a first part of the automation component AC is implemented by software, i.e. SW PLC. This first automation component AC transforms one or more control parameters of the set of control parameters determined into control instruction for a second automation component AC implanted in hardware, i.e. HW PLC. The automation instructions are subsequently carried out by the second automation component AC.

As evident, the production process carried out by the automation system AS may be a filling process and/or a mixing process. For example, the filling process may comprise the filling process and/or filling line as described in connection with Figure 1 to 4. In another example the mixing process and/or mixing assembly as described in connection with Figures 5 to 7. It should also be understood that the mixing process may be carried out before the filling process or the other way around. It should also be understood that the automation system AS may comprise both, a filling system and a mixing system and corresponding processes of filling and mixing. Of course other automation processes may be carried out instead of the filling and/or mixing process.

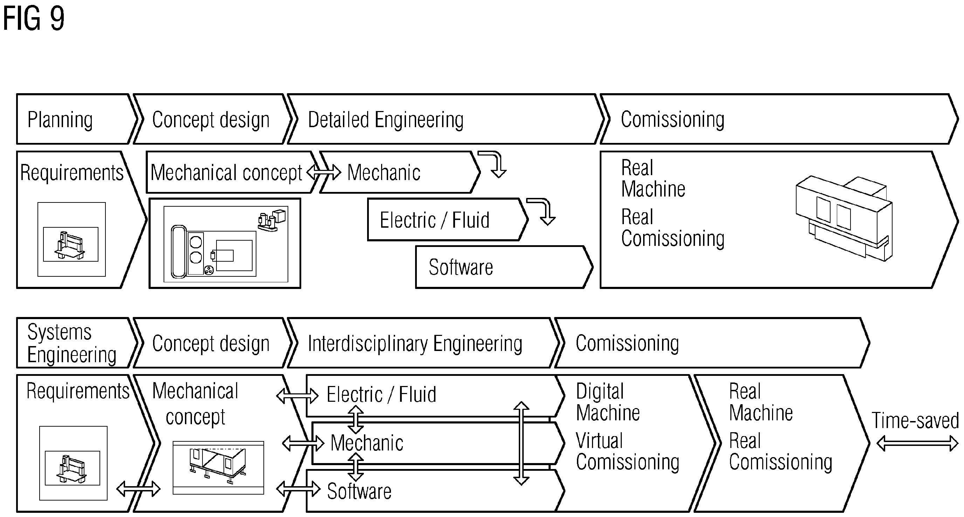

In Figure 9 advantages of an improved automation system AS are described. As can be seen a plurality of steps is necessary to set up production of an automation system AS. In a first step the requirements for the production are determined by way of planning and system engineering. Subsequently the requirements are translated in a mechanical concept comprising the hardware necessary to perform the production. The detailed concept may be influenced by the requirements determined and the specific properties of the automation components and/or the substance, in particular a fluid, that is processed. As can be seen the automation component(s) may comprise software and/or hardware. The choice of these components may have an effect on the mechanical concept. The same applies to the substance/fluid to be processed.

Following the detailed engineering the commissioning of the automation system has to be performed. The commissioning may comprise setting a set of control parameters and/or control instructions (e.g. derived from the set of control parameters). For the commissioning different control parameter values may be set in order to perform production. As is evident, a certain set of control parameters may lead to more efficient production than another set of control parameters. In order to determine an optimized set of control parameters use can be made of the method steps described herein, i.e. by way of virtual commissioning , that is to say by simulation of the automation component(s), e.g. the machines of the automation system. The virtual commissioning may be performed faster than a commissioning performed by trial and error on the actual machines. Thus the utilization of a simulation component, comprising one or more virtual models of the automation system may save time when setting up the automation system.

The suggested method(s) and system(s) may assist in rendering the production of respective product, may it be the filling of the container and/or the mixing of the substance in a container quicker, qualitatively better and more flexible. This may be achieved by linking and directly applying the result(s) of the simulation to the automation system for manufacturing said products.

The filling and/or the mixing, or other automation process, may be controlled by an automation component, such as an automation controller (PLC), and/or drives and/or electric motors which may be comprised by the automation component. In addition, the automation component may comprise switch gears and electrolysis inverters. The automation component may comprise a PLC Simatic S7-1500 of Siemens Aktiengesellschaft or a cluster of automation controllers. For the above-mentioned scenarios the control parameters may be imported into the controller for the drives and actuators that perform filling and/or mixing, and control the complete process. This implies that data from the simulation component and determination steps may be transmitted to the automation component which may then make use of those one or more parameters and/or transforms one or more of those control parameters into control set points for the drive component or drive system. For example different container types, such as different bottles or tanks, may produce different optimal mixing and/or filling scenarios. Taking into account the actual control parameters of the process which are present in the automation component, e.g. a controller and/or a sensor, as well the simulation result(s) with the control parameters determined, by way of simulation, may be used to change and/or adapt the parameters during the filling and/or mixing process.

After the simulation and determination steps have been performed by the simulation component, which may be part of a first device, e.g. a computer, and it is particularly advantageous to link the simulation component with the automation component, which may be part of a second device, through a communication system, e.g. point-to-point, a bus system, Ethernet, etc. The simulation component may as well be integrated in the automation component (or the other way around). Integration may be implemented by a (software) interface (between the automation component and the simulation component). The communication system may for example be wireless or wired.

Among the advantages of the suggested method and system is that a customer, e.g. an operator of a manufacturing facility, comprising container filling and/or mixing, for manufacturing products, may obtain all automation and simulation products out of one hand. The suggested integrated solution has a lot of benefits compared to a competitive solution where a customer would have multiple different suppliers instead of one, e.g. the responsibility for the complete installation is in one hand. Furthermore, the technical stability may more easily be guaranteed between the different products which are configured to cooperate and communicate seamlessly and compatibly. This may ensure an error-free connection of simulation results and car in process identity. Optimizing scenarios combined with automation will lead to better quality, e.g. consume less time and reduce costs, to a faster filling and/or mixing process which increases the through put and the revenues.

It should also be appreciated that, by way of example, the one or more set, i.e. pre-defined, conditions include at least one of minimum requirements such as a filling time, a maximum time duration, a mixing status, a mixing time and/or mixing power requirement or any combination thereof. Of course outer conditions may be set such as e.g. a allowed simulation runtime.

By way of example, a certain prioritization may be applied so that, e.g. the minimum requirements of the resulting filling and/or mixing process must be fulfilled for the selection of a simulated process. Then, if several sets of parameters fulfill this condition, some of these sets may still be dismissed if the maximum power requirement is exceeded. If at least two sets fulfill these two conditions, one can apply that control parameters may only be used if they do not exceed a maximum time duration. By way of example, if several sets of parameters determined fulfill one or more of the mentioned requirements, the one that has the shortest time duration for the filling and/or mixing may be chosen as the set of parameters to be applied, i.e. used as the actual parameters for controlling the filling and/or mixing.

In example embodiments, the method may further comprise through operation of the at least one processor determining a set of control parameters using the following input parameters: properties of the respective container, properties of the fluid and/or substance, and properties of automation component.

Using these input parameters, the simulation is enabled to give meaningful output with respect to the resulting filling and/or mixing, in particular the time duration required for the filling and/or mixing.

In order to refine the results of the simulation, additional input parameters may be included, such as, certain restraints of the respective automation component. Such restraints of the respective automation components may involve e.g. maxima of velocity, acceleration, tilting angle, tilt angular velocity and/or tilt angular acceleration, for example of a drive controlling a nozzle for filling and/or a drive for controlling the mixer/stirrer of the mixing process. Furthermore, depending on the specific application case further input parameters may be taken into account.

In further examples, the properties of the respective container, in particular in the case of the filling process, may comprise at least one of geometry, dimensions, material, stiffness, surface structure, temperature, electric potential, electric conductivity, or any combination thereof.

The properties of the respective container influence the process of filling the container and are thus taken into account for the simulation of the filling. Depending on the specific application, some of the mentioned properties may play an important role or may be neglected. In particular for simulating the geometry, the dimensions, the material, the stiffness and the surface structure may be important parameters of the container which should be used as input parameters. Furthermore, for simulating the geometry, the material, the surface structure, e.g. the plainness of the surface and the temperature may constitute relevant parameters of the container.

By way of example, the properties of the fluid and/or the substance may comprise at least one of material, density, temperature, viscosity, surface tension, electric potential, electric conductivity, or any combination thereof.

In general, the substance (as described in connection with the mixing process) may correspond to the fluid (as described in connection with the filling process) or may comprise the fluid.

Also, the properties of the fluid and/or the substance influence the process of filling and/or of mixing and may thus be taken into account for the simulation of the filling and/or mixing. Depending on the specific application, some of the mentioned properties may play an important role or may be neglected.

It should also be appreciated that, by way of example, the properties of the container may comprise at least one of geometry, dimensions, filling height of the fluid and/or the substance, information related to generated volumetric flow rate of the fluid or substance, information related to heating or cooling, electric potential, electric power, or any combination thereof.

The properties of the container may constitute relevant boundary conditions such as the geometry, the dimensions of the container and the filling height of the fluid and/or the substance. For some specific applications, additional features of the container may play a relevant role, such as a generated volumetric flow rate of the substance and/or the fluid, whereby its spatial distribution within the container may be of interest. Furthermore, properties of the fluid and/or the substance, the container and or the automation component may take into account changes of the mentioned parameters with elapsing time.

In further example embodiments, at least some of the properties of the respective container, the fluid and/or the substance, and/or the automation component may be provided to the at least one processor using at least one of a product lifecycle management (PLM) system, an engineering system, a manufacturing operation management (MOM) system, at least one sensor for sensing at least some of the properties, or any combination thereof. In these example embodiments the system may further comprise at least one of a PLM system, an engineering system, a MOM system, at the at least one sensor, or any combination thereof, whereby the at least one sensor is configured to send at least some of the properties of the respective container, fluid/substance and/or the automation component.

For example, at least some of the properties of the respective body may be provided to the at least one processor by a connected PLM system which includes information related to the respective container's geometry, dimensions, material and/or surface structure. The PLM system may provide this information e.g. in form of CAD data and/or a digital twin of the respective container. At least some of the properties of the fluid and/or substance may be provided by a connected PLM system or a connected MOM system which may include information related to the material, density, viscosity, carbonization and/or surface tension of the fluid and/or the substance. The MOM system may provide at least some of the properties of the fluid and/or the substance, e.g. temperature and/or electric potential, or at least some of the properties of the automation component which are described above.

Furthermore, the at least one sensor may provide at least one of properties of the respective container, e.g. the surface structure, temperature, electric potential, properties of fluid or substance,, e.g. temperature, viscosity, electric potential, properties of the dipping bath, e.g. electric potential, carbonization or any combination thereof. The at least one sensor may be connected to the at least one processor for transmission of information.

Additional information may be provided to the at least one processor including sequence information about a sequence of container and/or fluid to be filled at least partially by way of the automation component. This sequence information may be provided to the at least one processor by a MOM system and may comprise information about a first container and a subsequent second container and optionally about further containers. This sequence information consequently allows for taking into account the above-described more complex interaction processes - in particular if the container geometry and/or the fluid to be filled into the container changes.

In further examples, the method may further comprise through operation of the at least one processor performing at least the steps of determining a set of control parameters (based on simulating filling of the container at least partially with the fluid by way of the automation component) and causing the at least one automation component to at least partially fill the container according to at least one of the control parameters of the set of control parameters determined on-line and/or in real-time.

Similarly, In further examples, the method may further comprise through operation of the at least one processor performing at least the steps of determining a set of control parameters (based on simulating mixing of the at least one substance by way of the automation component) and causing the at least one automation component to mix the at least one substance in the container according to at least one of the control parameters of the set of control parameters determined online and/or in real-time.

Carrying out the mentioned steps on-line or in real-time renders the manufacturing process of the respective product, by filling a container and/or mixing a substance, very flexible and at the same time ensures optimal results with respect to the achieved filling process, e.g. filling level, and/or mixing process, e.g. degree of mixing, optionally the required time duration and/or optionally other involved properties mentioned above. To this end, corresponding steps of determining at least one set of control parameters are carried out in parallel to or immediately before causing the respective automation component to at least partially fill the container and/or to mix the at least one substance in the container. This realization of the suggested method and system is particularly interesting for the above-described sequence of containers or when some of the boundary conditions of the filling and/or mixing process are subject to change, e.g. the geometry of the container and/or the properties of the fluid and/or the substance.

In particular for the sequence of containers and for changing types of containers, other approaches involve stopping the filling and/or mixing and testing different sets of parameters by way of the simulation component. Of course, this is disadvantageous since the production is interrupted. Contrary to this approach, the suggested embodiment of the method and the system avoids these disadvantages by carrying out the mentioned steps on-line or in real-time. Consequently, the online and/or real-time handling of the mentioned steps can be used to update the set of control parameters when conditions, e.g. of the fluid and/or substance, the container and/or the automation component, change.

By way of example, the respective set of control parameters may comprise at least one of position, velocity, acceleration, tilt angle, tilt angular velocity, tilt angular acceleration, or any combination thereof. Of course, as mentioned in the above the control parameters determined by simulation, i.e. by way of the simulation component, may be processed in order to determine new parameters, e.g. by combining one or more of the control parameters determined. In the end the control parameters may correspond to the one that the automation component uses to control the process of filling and/or mixing.

The respective filling and/or mixing process may comprise the mentioned control parameters at least for the time duration of the filling and/or mixing respectively, i.e. when the respective container is filled with the fluid or the substance is mixed in the container. Here, the tilt angle, the tilt angular velocity and the tilt angular acceleration may refer to any spatial angle, e.g. in x-, y- or z-direction or any combination thereof. Thus for example a container and/or filling nozzle may be tilted with respect to each other. The container and/or the filling nozzle may for example be rotated at the start, the end or during the filling process, e.g. from a first to a second position. Further parameters may be taken into account, e.g. the rate of change of acceleration, or the tilt angular jerk.

It should also be appreciated that, by way of example, the method may further comprise through operation of the at least one processor determining control parameters to control the respective automation component such that it fills the container and/or it mixes the substance. This implies that the control parameters may be translated into control instructions for the respective one or more automation components. Of course the control parameters output by the simulation component may already correspond to the control instruction. By carrying out these control instructions, the respective automation component, such as a drive, which for example control operation of a conveyor belt or a mixing element, applies appropriate forces and/or torques on the respective conveyor belt, nozzle, fluid, substance and/or container so that the process of filling and/or mixing is performed. The mentioned further control parameters may, by way of example, comprise the geometry and the dimensions of the container and the density and the viscosity of the fluid and/or substance since a change of these parameters may require larger or smaller forces and/or torques for one and the same first trajectory. The determined control instructions may then be sent or applied to the respective automation component, such as one or more drives, in order to carry out corresponding actions.

In yet further example embodiments, the method may further comprise through operation of the at least one processor performing at least the steps of determining a first set of control parameters and subsequently determining a second set of control parameters. Thus in case an update of the properties of the container, the fluid and/or the automation component is available, an updated set of control parameters based on simulating filling of the container at least partially with the fluid based on the one or more updated properties of the container, the fluid and/or the automation component, is provided. Subsequently by way of operation of the at least one processor the at least one automation component is caused to at least partially fill the container according to at least one of the control parameters of the updated set of control parameters determined. This may also apply to the process of mixing one or more substance in a container, i.e. when the container, the substance and/or one or more automation components are updated. This is an example of the above-mentioned, more complex interaction processes. Consequently, this aspect of the invention may also be applied to a sequence of a first container and/or fluid and a second container and/or fluid and optionally further containers and/or fluid for which the mentioned steps are carried out, respectively. Here, the term "seamlessly" shall mean that the second container and/or fluid follows the first body without undue delay or waiting time so that a continuous and fluent manufacture and movement of the sequence of containers may be ensured. A waiting time being larger than e.g. 150 % of a minimal waiting time may be considered an undue delay.

The seamless movement of the containers and/or automation component, such as a filling nozzle or a mixer/stirrer, may, by way of example, be achieved by carrying out the steps of determining a respective set of control parameters. The respective determined first and/or second set of control parameters may then be stored in the at least one memory, i.e. a storage. Later, when the respective manufacturing scenario, e.g. an update of the properties, occurs, the determined corresponding first set of parameters may be loaded by the at least one processor from the at least one memory and the at least one processor causes the respective automation component to act accordingly, i.e. to at least partially fill the container and/or mix the substance in the container. An update of the automation component may for example comprise upgrading the software, e.g. firmware of the automation component, adding additional functions implemented in software to the automation component and/or replacing one or more hardware parts of the automation component, e.g. replacing a certain impeller geometry with another impeller geometry, and/or completely replacing an automation component with another automation component having different properties.

Another way to ensure a seamless movement of the two containers may, e.g., be achieved by performing at least the steps of determining a set of control parameters and causing the at least one automation component fill the container and/or mix the substance on-line and/or in real-time.

The mentioned seamless movement is in particular of interest if the sequence of updates comprises container of different types and/or fluids and/or substances of different types. However, an update of an automation component may also improve functionality of the component and may thus be taken into account when optimizing the filling and/or mixing process.

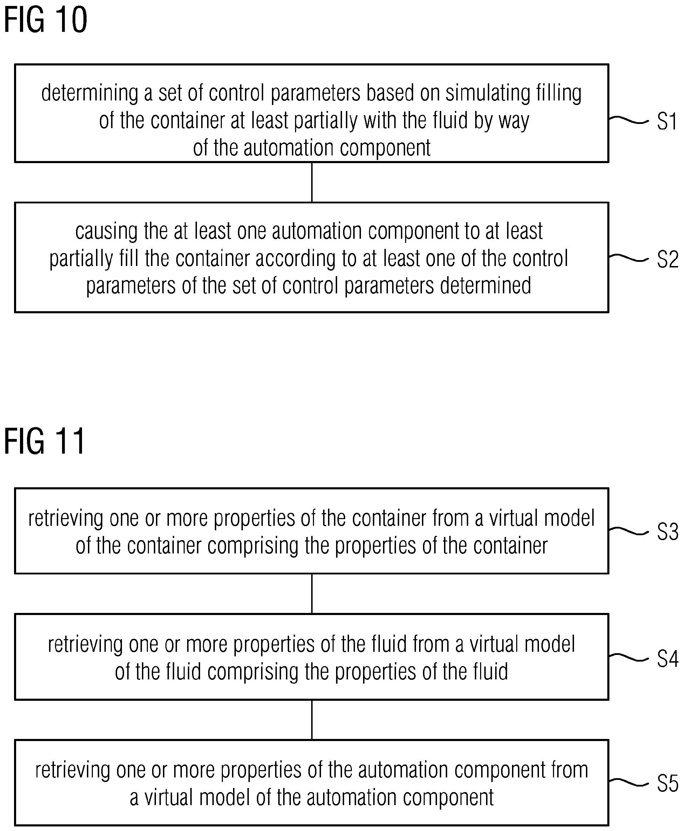

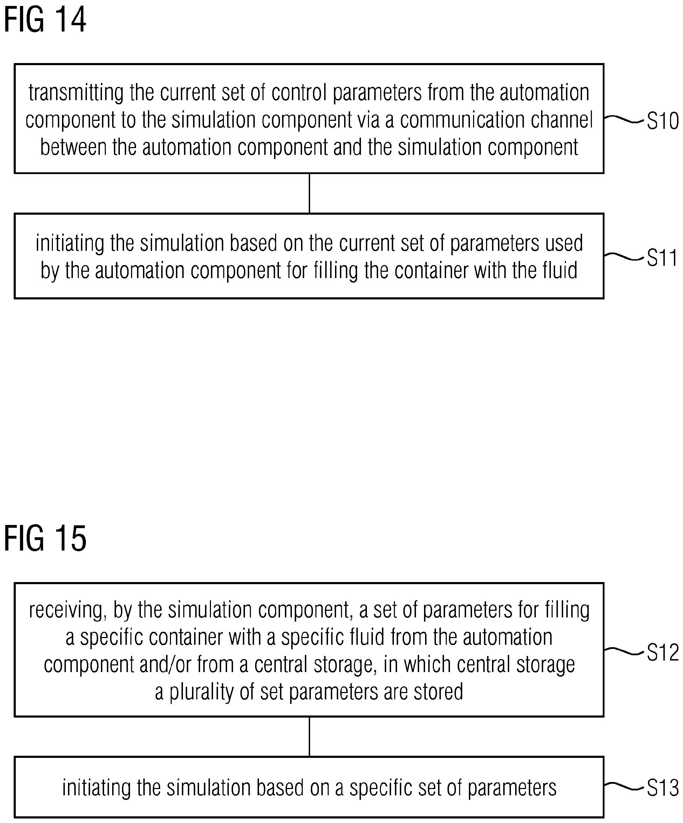

The method steps as described in the above relating to the filling process are also illustrated in Figure 10 to 15.

Hence in a step S1 a set of control parameters based on simulating filling of the container at least partially with the fluid by way of the automation component is determined. Subsequently in a step S2 the at least one automation component may be caused to at least partially fill the container according to at least one of the control parameters of the set of control parameters determined. It should be understood that the steps S1 and S2 can be repeated, e.g. starting with step S1.

In a step S3 one or more properties of the container from a virtual model of the container comprising the properties of the container may be retrieved, e.g. from a central storage or from the automation component. In a step S4 one or more properties of the fluid from a virtual model of the fluid comprising the properties of the fluid may be retrieved, e.g. from a central storage or from the automation component. In a step S5 one or more properties of the automation component may be retrieved from a virtual model of the automation component. It should be understood that the sequence of steps S3, S4 and S5 may be varied. It should also be understood that the properties may be retrieved by measurement performed by the automation component and/or may be historic data previously stored in a memory, such as the central storage.

It should be understood that the steps S3, S4 and S5 may be combined with steps S1 and S2.

In a step S6 an updated set of control parameters based on simulating filling of the container may be determined, e.g. if the container, that is to say the containers properties, the automation component, that is to say the automation components properties, e.g. due to a software and/or hardware update, and/or the fluid, that is to say the fluids properties, changes.

Subsequently in a step S7 the at least one automation component may be caused to at least partially fill the container according to at least one of the control parameters of the updated set of control parameters determined. It should be understood that steps S6 and S7 may be repeated, in particular in combination with any one of the steps S3, S4 and S5.

In a step S8 the set of control parameters determined (by the simulation component) may be stored in a memory, e.g. the central storage. In a subsequent step S9 the set of control parameters determined may be transmitted to the automation component, preferably via a communication channel between the simulation component and the automation component. It should be understood that the automation component itself may check for updated regarding one or more control parameters, that is to say a set of updated control parameters. Step S8 and/or S9 may thus be repeated, e.g. in a periodic or event based manner.

In a step s10 the current set of control parameters may be transmitted from the automation component to the simulation component via a communication channel between the automation component and the simulation component. Thereby the set of control parameters currently in use by the automation component may form the basis, i.e. the starting point, of an optimization process. Simulation is thus started based on the current control parameters in use. As has been described in depth in the above control parameters may correspond to the properties of the automation component itself, the properties if the fluid and/or the properties of the container.

In a step S11 the simulation may be initiated based on the current set of parameters used by the automation component for filling the container with the fluid. Hence a defined starting point may be provided for starting the simulation.

In a step S12 a set of parameters for filling a specific container with a specific fluid is received by the simulation component from the automation component and/or from a central storage, in which central storage a plurality of set of parameters are stored. Thereby, the container, fluid and/or automation component currently in use by the automation system may be used by the simulation component as this information is for the most of the time present in the automation system only. For example, if an operator of an automation component or automation system adjusts the settings of the automation component and/or of the automation system, e.g. by changing one or more control parameters, the resulting control parameters may be received by the simulation component. Subsequently in a step S13 the simulation based on the specific set of parameters may be initiated. That is to say, the simulation is performed by the simulation component. It should be understood that the steps S12 and S13 may be repeated as well.

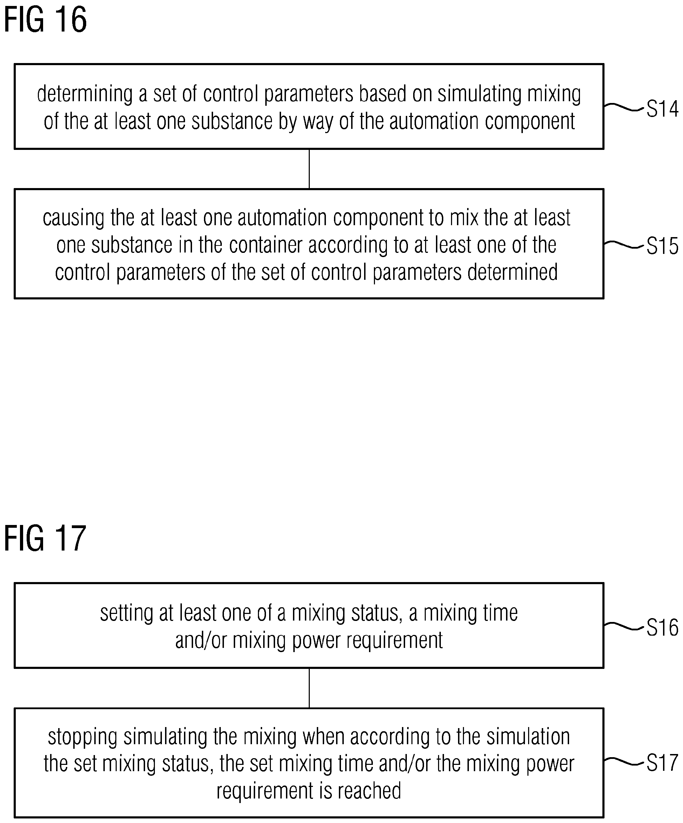

In Figure 16 to 19 method steps as described in the above relating to the mixing process are also illustrated.
In a first step S14 a set of control parameters based on simulating mixing of the at least one substance by way of the automation component may be determined. Subsequently in a step S15 the at least one automation component may be caused to mix the at least one substance in the container according to at least one of the control parameters of the set of control parameters determined. It should be understood that steps S14 and S15 may be repeated. It should also be clear that the simulation may take into account one or more properties of the container, the automation component and/or the one or more substances -a described in the above- for example by way of a virtual model of the container, the fluid and/or the one or more automation components.

In a step S16 at least one of a mixing status, a mixing time and/or mixing power requirement may be set. Of course other conditions may be set in order to abort simulation and obtain a set of control parameters from the simulation component. Of course one or more control parameters may be retrieved before abortion of the simulation, i.e. during runtime of the simulation. Thus, in a step S17 simulating the mixing may be stopped when according to the simulation the set mixing status, the set mixing time and/or the mixing power requirement is reached.

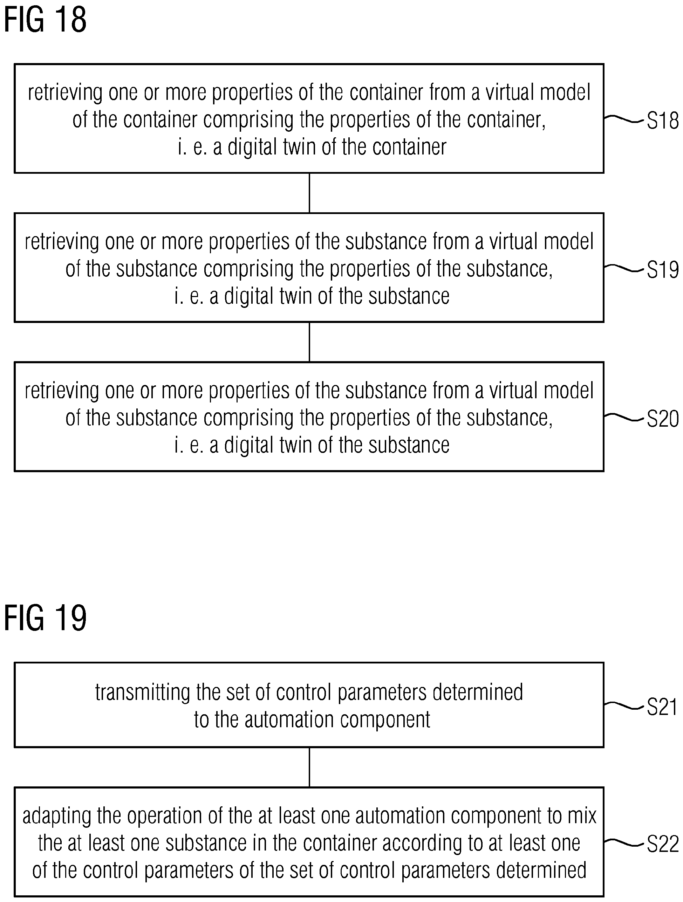

For step SS18, S19 and S20 in Figure 18 reference is made to steps S3, S4 and S5 of Figure 11 and the corresponding description.

As with the filling process now with regard to the mixing process the set of control parameters determined to the automation component may be transmitted, e.g. to the automation component, in a step S21. In a subsequent step S22 the operation of the at least one automation component may be adapted to mix the at least one substance in the container according to at least one of the control parameters of the set of control parameters determined.

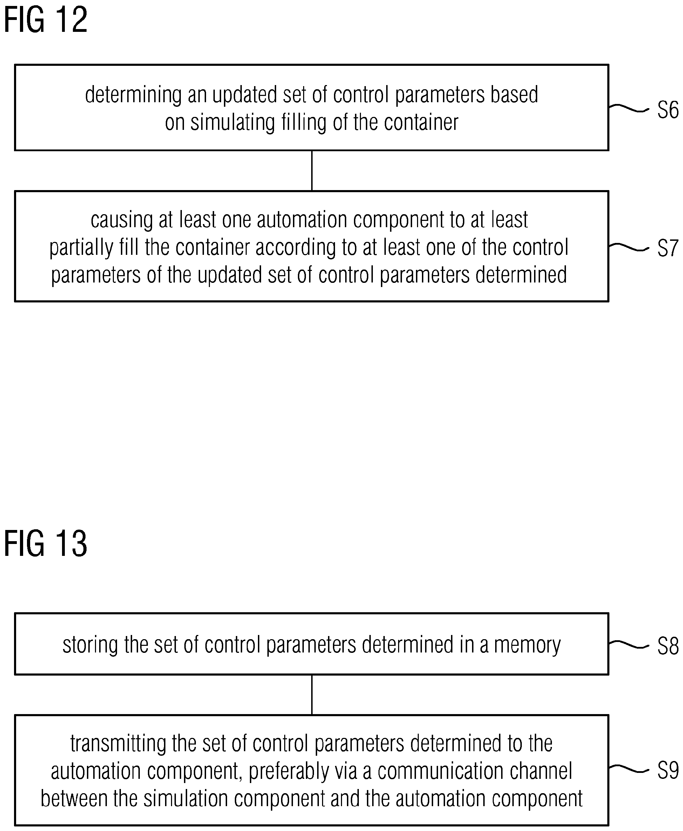

Furthermore, for example the steps S8 and/or S9 of Figure 13 may also be performed in connection with the method of mixing a substance. That is to say, the set of control parameters determined may be stored in a memory, for example the central storage. In a subsequent the set of control parameters determined may be transmitted to the automation component, preferably via a communication channel between the simulation component and the automation component. It should be understood that the only a subset of the control parameters determined may be stored in said memory and/or transmitted to the automation component.

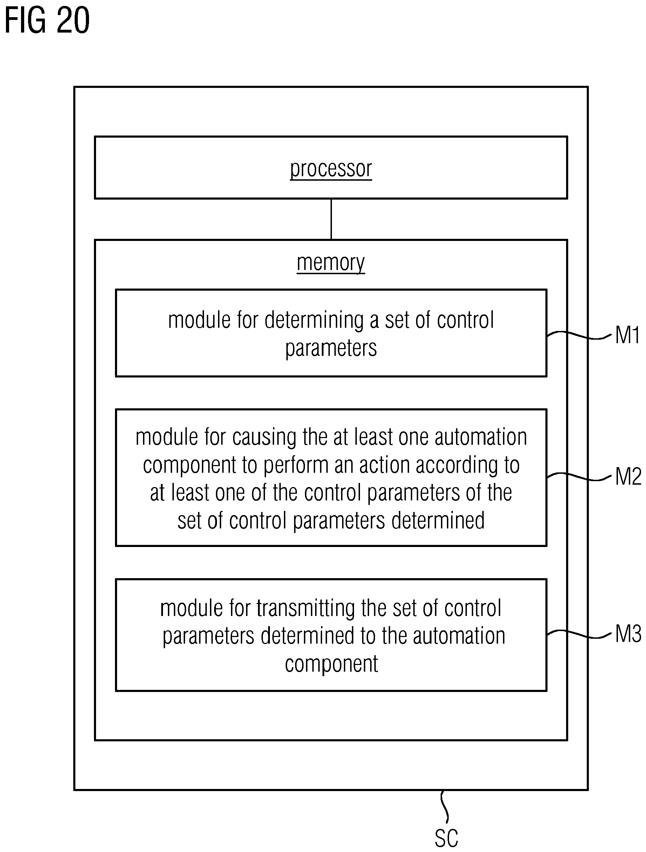

Now turning to Figure 20, a simulation component SC is shown. The simulation component may comprise a memory and a processor. The memory may comprise one or more modules. For example a module M1 may serve for determining a set of control parameters. A module M2 may serve for causing the at least one automation component to perform an action according to at least one of the control parameters of the set of control parameters determined. This may encompass transmitting one or more messages to the automation component. A module M3 of the simulation component may serve for transmitting the set of control parameters determined to the automation component.

Thus, one or more modules of the simulation component may be combined to form a single module.

Of course, further modules may exist that implement the functions of any one of the method steps as presented in Figures 10 to 19.

It should be understood that the action as described in module M2 may be either filling of a container or mixing of a substance in a container but that also other automation tasks may be performed.

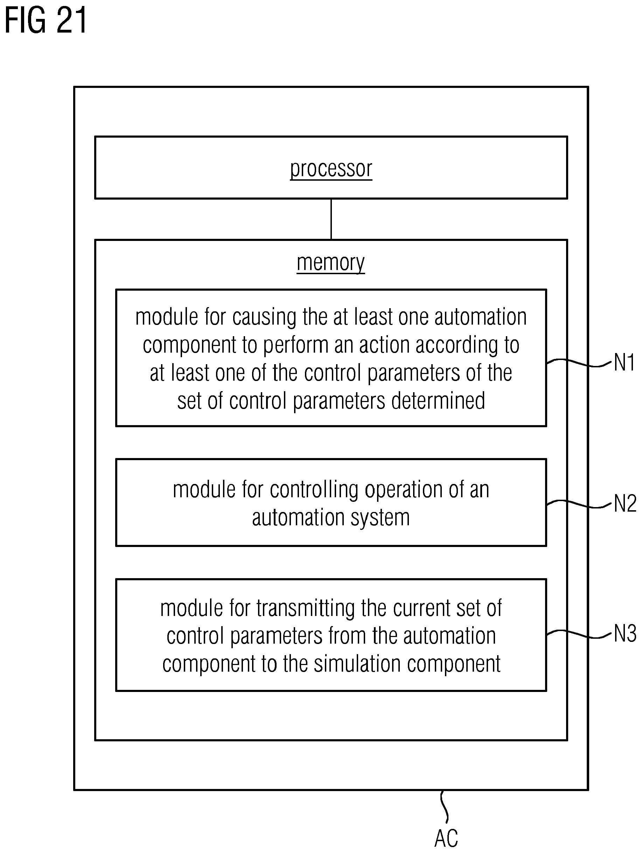

Now turning to Figure 21, an automation component is shown. The automation component may also comprise a memory and a processor. This may be a memory and/or processor separate from the memory and/or processor of the simulation component or may be the same memory and/or processor. That is to say only one memory and/or processor may be present in order to carry out the functions of the simulation component and the automation component.

The memory of the automation component may comprise a module N1 for causing the at least one automation component to perform an action according to at least one of the control parameters of the set of control parameters determined. The memory may further comprise a module N2 for controlling operation of an automation system. The automation system may correspond to the automation component but may also comprise more than one automation component. Furthermore, the automation component may comprise a module N3 for transmitting the current set of control parameters from the automation component to the simulation component.

One or more modules of the automation component may be combined to form a single module.

Of course, further modules may exist that implement the functions of any one of the method steps as presented in Figures 10 to 19.

It should also be understood that the action as described in module N1 may be either filling of a container or mixing of a substance in a container but that also other automation tasks may be performed.

Another example may include a product or apparatus including at least one hardware, software, and/or firmware based processor, computer, component, controller, means, module, and/or unit configured for carrying out functionality corresponding to this described method.

It should be appreciated that the simulation can be carried out on a first device, e.g. a computer or a cluster of computers or processors, whereas the control of the respective drive component is carried out by second device, e.g. an automation controller, for example like the PLC Simatic S7-1500 of Siemens Aktiengesellschaft, or a cluster of automation controllers.

Further, the term "component" means any device, system or part thereof that controls at least one operation, whether such a device is implemented in hardware, firmware, software or some combination of at least two of the same. It should be noted that the functionality associated with any particular controller may be centralized or distributed, whether locally or remotely.

Those of ordinary skill in the art will appreciate that the hardware depicted for the simulation component and/or the automation component may vary for particular implementations. For example, a computer, workstation, server, PC, notebook computer, tablet, mobile phone, and/or any other type of apparatus/system that is operative to process data and carry out functionality and features described herein associated with the operation of a data processing system, computer, processor, and/or a controller discussed herein may be used. The depicted example is provided for the purpose of explanation only and is not meant to imply architectural limitations with respect to the present disclosure.

Also, it should be noted that the processor described herein may be located in a server that is remote from process plant. In such an example, the described embodiments a client device that communicates with the server (and/or a virtual machine executing on the server) through a wired or wireless network (which may include the Internet) may be provided. In some embodiments, such a client device, for example, may execute a remote desktop application or may correspond to a portal device that carries out a remote desktop protocol with the server in order to send inputs from an input device to the server and receive information from the server. Examples of such remote desktop protocols include Teradici's PCoIP, Microsoft's RDP, and the RFB protocol. In such examples, the processor described herein may correspond to a virtual processor of a virtual machine executing in a physical processor of the server.

As used herein, the terms "component" and "system" are intended to encompass hardware, software, or a combination of hardware and software. Thus, for example, a system or component may be a process, a process executing on a processor, or a processor. Additionally, a component or system may be localized on a single device or distributed across several devices.

Also, as used herein a processor corresponds to any electronic device that is configured via hardware circuits, software, and/or firmware to process data. For example, processors described herein may correspond to one or more (or a combination) of a microprocessor, CPU, FPGA, ASIC, or any other integrated circuit (IC) or other type of circuit that is capable of processing data in a data processing system, which may have the form of a controller board, computer, server, mobile phone, and/or any other type of electronic device.

Also, although the terms "first", "second", "third" and so forth may be used herein to describe various elements, functions, or acts, these elements, functions, or acts should not be limited by these terms. Rather these numeral adjectives are used to distinguish different elements, functions or acts from each other. For example, a first element, function, or act could be termed a second element, function, or act, and, similarly, a second element, function, or act could be termed a first element, function, or act, without departing from the scope of the present disclosure.

In addition, phrases such as "processor is configured to" carry out one or more functions or processes, may mean the processor is operatively configured to or operably configured to carry out the functions or processes via software, firmware, and/or wired circuits. For example, a processor that is configured to carry out a function/process may correspond to a processor that is executing the software/firmware, which is programmed to cause the processor to carry out the function/process and/or may correspond to a processor that has the software/firmware in a memory or storage device that is available to be executed by the processor to carry out the function/process. It should also be noted that a processor that is "configured to" carry out one or more functions or processes, may also correspond to a processor circuit particularly fabricated or "wired" to carry out the functions or processes (e.g., an ASIC or FPGA design). Further the phrase "at least one" before an element (e.g., a processor) that is configured to carry out more than one function may correspond to one or more elements (e.g., processors) that each carry out the functions and may also correspond to two or more of the elements (e.g., processors) that respectively carry out different ones of the one or more different functions.

Although an exemplary embodiment of the present disclosure has been described in detail, those skilled in the art will understand that various changes, substitutions, variations, and improvements disclosed herein may be made without departing from the spirit and scope of the disclosure in its broadest form.

## Claims

1. A method of filling a container (C) with a fluid (F) by way of at least one automation component (AC), the method comprising, through operation of at least one processor:
determining (S1) a set of control parameters based on simulating filling of the container (C) at least partially with the fluid (F) by way of the automation component (AC), wherein the simulating takes into account one or more properties (P1, ..., Pn) of the container (C), the fluid (F) and/or the at least one automation component (AC); and
causing (S2) the at least one automation component (AC) to at least partially fill the container (C) according to at least one of the control parameters of the set of control parameters determined.

2. The method according to the preceding claim,
wherein the one or more properties (P1, ..., Pn) of the container (C) comprise at least one of geometry, stiffness, dimensions, material, surface structure, temperature, electric potential, electric conductivity, or any combination thereof, and/or
wherein the one or more properties (P1, ..., Pn) of the fluid (F) comprise at least one of material, density, temperature, viscosity, surface tension, electric potential, electric conductivity, carbonization or any combination thereof, and/or wherein the one or more properties of the automation component (AC) comprises at least one of position, velocity, acceleration, tilt angle, tilt angular velocity, tilt angular acceleration, or any combination thereof of the automation component (AC).

3. The method according to any one of the preceding claims, wherein the step of simulating (S1) comprises retrieving (S3) one or more properties (P1, ..., Pn) of the container (C) from a virtual model (VM) of the container (C) comprising the properties (P1, ..., Pn) of the container (C), i.e. a digital twin of the container (C), and/or
wherein the step of simulating (S1) comprises retrieving (S4) one or more properties (P1, ..., Pn) of the fluid (F) from a virtual model (VM) of the fluid (F) comprising the properties (P1, ..., Pn) of the fluid (F), i.e. a digital twin of the fluid (F),
wherein the step of simulating (S1) comprises retrieving (S5) one or more properties (P1, ..., Pn) of the automation component (AC) from a virtual model (VM) of the automation component (AC).

4. The method according to any one of the preceding claims, wherein in case an update of the properties (P1, ..., Pn) of the container (C), the fluid (F) and/or the automation component (AC) is available,
determining (S6) an updated set of control parameters based on simulating filling of the container (C) at least partially with the fluid (F) based on the one or more updated properties of the container (C), the fluid (F) and/or the automation component (AC),
and causing (S7) at least one automation component to at least partially fill the container (AC) according to at least one of the control parameters of the updated set of control parameters determined.

5. The method according to any one of the preceding claims, storing (S8) the set of control parameters determined in a memory, and/or transmitting (S9) the set of control parameters determined to the automation component, preferably via a communication channel (IF), e.g. an interface, between the simulation component (SC) and the automation component (AC).

6. The method according to any one of the preceding claims, receiving, by the simulation component, a set of parameters for filling a specific container with a specific fluid from the automation component (AC) and/or from a central storage, in which central storage a plurality of set of parameters are stored.

7. The method according to any one of the preceding claims, initiating (S11) the simulation based on a current set of parameters used by the automation component (AC) for filling the container (C) with the fluid,
transmitting (10) the current set of control parameters from the automation component (AC) to the simulation component (SC) via a communication channel (IF) between the automation component (AC) and the simulation component (SC).

8. The method according to any one of the preceding claims, wherein the automation component (AC) and the simulation component (SC) are integrated and run on a single processor or multi-processor hardware.

9. A computer program product comprising program code that when executed, cause at least one processor to carry out any one of the method steps of claims 1 to 8.

10. A method of operating a mixing system (MS), the mixing system (MS) comprising a container (C), at least one substance (S) to be mixed, and at least one automation component (AC) for performing the mixing, the method comprising, through operation of at least one processor:
determining (S14) a set of control parameters based on simulating mixing of the at least one substance (S) by way of the automation component (AC), wherein the simulating takes into account one or more properties (P1, ..., Pn) of the container (C), the least one substance (S) and/or the at least one automation component (AC); and
causing (S15) the at least one automation component (AC) to mix the at least one substance (S) in the container (C) according to at least one of the control parameters of the set of control parameters determined.

11. The method according to the preceding claim, further comprising the steps of:
setting (S16) at least one of a mixing status, a mixing time and/or mixing power requirement;
stopping (S17) simulating the mixing when according to the simulation the set mixing status, the set mixing time and/or the mixing power requirement is reached.

12. The method according to any one of the preceding claims 10 to 11,
wherein the step of simulating comprises retrieving (S18) one or more properties (P1, ..., Pn) of the container (C) from a virtual model (VM) of the container (C) comprising the properties (P1, ..., Pn) of the container C(), i.e. a digital twin of the container, and/or
wherein the step of simulating comprises retrieving (S19) one or more properties (P1, ..., Pn) of the substance (S) from a virtual model of the substance (S) comprising the properties of the substance (S), i.e. a digital twin of the substance, wherein the step of simulating comprises retrieving (S20) one or more properties of the automation component (AC) from a virtual model (VM) of the automation component (AC).

13. The method according to any one of the preceding claims 10 to 12,
transmitting (S21) the set of control parameters determined to the automation component (AC), preferably via a communication channel (IF) between the simulation component (SC) and the automation component (AC),
adapting (S22) the operation of the at least one automation component (AC) to mix the at least one substance (S) in the container (C) according to at least one of the control parameters of the set of control parameters determined.

14. The method according to any one of the preceding claims 10 to 13,
initiating the simulation based on a current set of parameters used by the automation component (AC) for mixing the substance in the container (C), preferably during the actual mixing is performed by the automation component (AC).

15. A computer program product comprising program code that when executed, cause at least one processor to carry out any one of the method steps of claims 10 to 14.
